# EUROPÄISCHE PATENTSCHRIFT

(11) **EP 2 795 127 B1**
(45) Veröffentlichungstag und Bekanntmachung des Hinweises auf die Patenterteilung: **16.03.2016**
(21) Anmeldenummer: 12812650.5
(22) Anmeldetag: 21.12.2012
(51) Int. Cl.: F04B 39/06, F04B 39/12, F04B 39/16, F04B 53/08, F04B 53/16, B01D 5/00, B01D 53/26, F25B 21/02, H05K 5/02

(54) **GERÄTEGEHÄUSE MIT KÜHLVORRICHTUNG FÜR EINSTRÖMENDE LUFT**
MACHNINE HOUSING HAVING A COOLING DEVICE FOR ENTERING AIR
BOÎTIER D'UN APPAREIL AVEC DES MOYENS POUR REFROIDIR DE L'AIR ENTRANT LEDIT BOÎTIER

(30) Priorität: 22.12.2011 DE 102011121926
(43) Veröffentlichungstag der Anmeldung: 29.10.2014
(73) Patentinhaber: Robert Bosch GmbH, 70442 Stuttgart (DE)
(72) Erfinder: KILAST, Bernd, 71277 Rutesheim (DE); LEWANDOWSKI, Marek, 71706 Markgroeningen (DE)
(86) Internationale Anmeldenummer: PCT/EP2012/076621
(87) Internationale Veröffentlichungsnummer: WO 2013/092993

(56) Entgegenhaltungen:
- DE-A1- 10 245 103
- DE-A1- 19 918 161
- US-A- 4 499 736
- US-A- 5 884 486
- US-B1- 6 250 083

## Beschreibung

Die Erfindung betrifft ein Gehäuse für ein Gerät zum Betreiben einer Klimatisierungsanlage, insbesondere einer Wärmepumpe, mit im Gehäuseinneren angeordneten elektrischen Verbrauchern und Mitteln zum Abführen der von den elektrischen Verbrauchern erzeugten Abwärme. Außerdem betrifft die Erfindung ein Gerät zum Betreiben einer Klimatisierungsanlage und/oder eine Klimatisierungsanlage mit einem solchen Gehäuse.

Für die nachfolgende Erfindung sollen unter den Begriff Gerät" all diejenigen über entsprechende Mittel gekühlten oder kühlbaren Geräte mit im Gerätegehäuse angeordneten und Abwärme erzeugenden elektrischen Verbrauchern fallen, die zum Betreiben einer Klimatisierungsanlage, beispielsweise einer Wärmepumpe, Kältemaschine oder sonstiger Heiz- und Kühlanlagen, dienen können, also zum Beispiel Steuergeräte, Strom- und Spannungsversorgungsgeräte, Antriebsmotoren. Kompressoren oder Pumpen.

Gehäuse und Geräte der eingangs genannten Art mit Mitteln zum Abführen der im Gehäuseinneren erzeugten Abwärme sind aus dem Stand der Technik bekannt. So beschreibt beispielsweise die DE 199 18 161 A1 eine Kältemittelverdichtungsanlage mit einem von einem Drehstrommotor angetriebenen Verdichter, bei der der Drehstrommotor durch das Kältemittel der Anlage aktiv gekühlt ist. Für den Betrieb des Motors ist ein Umrichter vorgesehen, dessen elektrische Leistungsbauteile thermisch mit dem Gehäuse des aktiv gekühlten Drehstrommotors gekoppelt sind. Insgesamt ist damit eine effektive thermische Ankopplung der in den Leistungsbauteilen des Umrichters anfallenden Wärmemengen an das Kältemittel und somit eine effiziente Wärmeabfuhr aus dem Umrichter an das Kältemittel gewährleistet.

Allerdings tauschen derartige Geräte, bei denen das Geräteinnere beispielsweise nicht durch ein absolut luftdichtes Gehäuse gegenüber der Gehäuseumgebung abgeschlossen ist, bei jedem Temperaturwechsel eine bestimmte Menge Luft mit der Gehäuseumgebung aus, da zwischen Gehäuseumgebung und Gehäuseinnerem bedingt durch den Temperaturwechsel ein Temperatur- und damit auch ein Druckgradient entsteht. Dabei kann durch einströmende Luft Feuchtigkeit in das Gehäuseinnere transportiert werden. Bei aktiv gekühlten Geräten, wie beispielsweise einem Steuergerät für eine Wärmepumpe, welches nach dem Einschalten des Kompressors durch das Kältemittel häufig auf eine deutlich niedrigere Temperatur als die Luft in der Gehäuseumgebung abgekühlt wird, besteht die Gefahr, dass Elektronikbauteile der elektrischen Verbraucher im Inneren des Steuergerätes durch die aus der Geräteumgebung eindringende, warmfeuchte Luft betaut werden. Infolgedessen kann es möglicherweise zu Beschädigungen an der Elektronik durch elektrochemische Korrosion bzw. elektrisch leitfähige Betauung kommen, die unter anderem zum Totalausfall des Gerätes führen können.

Ferner sind weitere Gehäuse aus der US 5 884 486 A, US 6 250 083 B1, US 4 499 736 A bekannt.

Aus dem Stand der Technik sind verschiedene Lösungsansätze bekannt, die eine Feuchteeinwirkung und die daraus resultierende Probleme verhindern sollen. Diese Ansätze umfassen beispielsweise den Einsatz von Trocknungsmitteln im Geräteinneren, luftdichte Gehäuse, eine dauerhafte Beheizung des Steuergeräts oder Schutzlackierungen der Leiterplatten und Elektronikbauteile.

Allerdings sind derartige Lösungsansätze häufig mit einem zusätzlichen technischen und damit auch finanziellen Aufwand verbunden. So müssen zum Beispiel im Falle von luftdichten Gehäusen Kabelgänge zwischen dem Gehäuseinneren und -äußeren mitunter gasdicht ausgebildet sein. Außerdem sind andere Lösungsansätze, wie der Einsatz von Trocknungsmitteln oder eine Schutzlackierung, nur auf den Schutz vor den Folgen der Feuchteeinwirkung, nicht aber auf deren Ursache, nämlich die Betauung, ausgerichtet, so dass die eindringende Feuchte gegebenenfalls immer noch über andere Wirkmechanismen als diejenigen, die durch die jeweiligen Schutzmaßnahmen symptomatisch beeinflusst werden, Schaden an der Elektronik im Gehäuseinneren verursachen kann.

Aufgabe der vorliegenden Erfindung ist es daher, ein Gehäuse für ein Gerät der eingangs genannten Art anzugeben, durch das das Risiko einer Betauung der im Inneren des Gehäuses angeordneten und Abwärme erzeugenden Elektronik minimiert wird.

Diese Aufgabe wird durch Gehäuse gemäß dem Oberbegriff des Patentanspruchs 1 erfindungsgemäß dadurch gelöst, dass im Bereich der Gehäusewandung eine Kühleinrichtung zum Kondensieren der in der in das Gehäuseinnere einströmenden Umgebungsluft enthaltenen Feuchtigkeit vorgesehen ist, d.h. die Kühleinrichtung kühlt die in das Gehäuseinnere einströmende Umgebungsluft derart ab, dass die darin enthaltene Feuchtigkeit noch vor dem Eindringen der Umgebungsluft in das Gehäuseinnere im Wesentlich auskondensiert ist.

Nach der Erfindung bildet die Kühlvorrichtung zusammen mit wenigstens einer Gehäuseöffnung im Gehäuse eine Zwangsströmungsverbindung für die aus der Gehäuseumgebung in das Innere des Gehäuses einströmende Umgebungsluft. Dabei ist das Gehäuse bis auf die wenigstens eine Gehäuseöffnung im Wesentlichen luftdicht ausgebildet. Dadurch wird erreicht, dass die einströmende Umgebungsluft zwangsweise nur über die Kühleinrichtung und die Gehäuseöffnung in das Gehäuseinnere gelangen kann, d. h. über einen definierten Weg geführt bzw. geleitet wird.

Außerdem kann diese für die einströmende Luft bestimmte Gehäuseöffnung anstelle zusätzlicher Durchgangsöffnungen vorteilhafterweise als Durchführung für Kabelverbindungen zwischen den elektrischen Verbrauchern im Gehäuseinneren und außerhalb des Gehäuses angeordneten Bauteilen dienen, so dass das Gehäuse bis auf die Einlassöffnung ansonsten luftdicht ausgebildet sein kann.

Erfindungsgemäß wurde hierbei erkannt, dass die im Gehäuseinneren Schaden verursachende Feuchtigkeit vor allem durch die Temperaturverhältnisse am Gerät während der kritischen Phasen des Ein- und Ausschaltens bedingt wird. Beim Einschalten bzw. Hochfahren der Klimatisierungsanlage werden die elektrischen Verbraucher, zum Beispiel die Elektronikbauteile des Geräts, zunächst sehr schnell warm, und damit auch die Luft im Gehäuseinneren. Diese relativ trockene Luft weicht aus dem insbesondere nicht luftdichten Gehäuse in die Gehäuseumgebung aus. Nach einer bestimmten Zeit stabilisiert sich die Temperatur im Gehäuseinneren durch die einsetzende Kühlwirkung jener Mittel. die zum Abführen der von den elektrischen Verbrauchern erzeugten Abwärme bestimmt sind. Insbesondere dann, wenn die Kühlung gegen den Kältekreislauf der Klimatisierungsanlage erfolgt, kann die Temperatur im Gehäuseinneren auf Werte unterhalb der Lufttemperatur in der Gehäuseumgebung absinken. Dadurch sinkt auch der Luftdruck im Inneren des Gehäuses, so dass warme und feuchte Luft aus der Gehäuseumgebung ins Innere eingesaugt wird. Da dem Gerät im Gehäuseinneren die Wärme entzogen wurde, steigt dort die relative Luftfeuchtigkeit unter Umständen derart an, dass es zu einer Betauung im Gehäuseinneren kommen kann. Vornehmlich allerdings zunächst auf der Innenseite des Gehäuses, nicht aber auf den trotz Kühlung dennoch warmen elektrischen Verbrauchern. Beim Abschalten des Geräts und ggf. der Klimatisierungsanlage fällt die Abwärme der Elektronik jedoch weg, so dass die Temperatur der elektrischen Verbraucher zunächst sehr schnell, eventuell bis auf die Temperatur des kühleren Kältekreislaufs, abfällt. Dadurch kann sich die Feuchte im Gehäuseinneren nun auch an den elektrischen Verbrauchern, insbesondere an den sich am schnellsten abkühlenden Elektronikbauteilen wie Leistungshalbleiter niederschlagen. Diese sind häufig thermisch besonders gut, beispielsweise über die Leitergrundplatine, an die Gerätekohlung und ggf. an den Kältekreislauf der Klimatisierungsanlage gekoppelt. Spätestens beim Wiedereinschalten des Geräts und der Klimatisierungsanlage kann es dann zu einer Beschädigung an der betauten Elektronik durch sogenannte heiße elektrochemische Korrosion kommen.

Dahingegen kann durch die erfindungsgemäß im Bereich der Gehäusewandung vorgesehene Kühleinrichtung eine Betauung der elektrischen Verbraucher im Gehäuseinneren verhindert werden, indem die in das Gehäuse einströmende Luft noch vor dem Erreichen des Gehäuseinneren derart abgekühlt wird, dass sich der Großteil der in der einströmenden Umgebungsluft enthaltenen Feuchte an der Kühleinrichtung abscheidet. Vorzugsweise hat die so abgekühlte und getrocknete einströmende Luft beim Eindringen in das Gehäuseinnere eine niedrigere Temperatur als die Gehäuseinnenluft, die Gehäuseinnenwand bzw. die Elektronikoberfläche. Vorzugsweise ist die Kühleinrichtung an der Außenseite des Gehäuses angeordnet.

Nach einer ersten Ausgestaltung der Erfindung ist die Kühleinrichtung als passives Bauteil ausgebildet und steht mit den Mitteln zum Abführen der von den elektrischen Verbrauchern erzeugten Abwärme, insbesondere über das Gehäuse, in thermischem Kontakt. Damit wird in vorteilhafter Weise erreicht, dass für die Kühlaufgabe der Kühleinrichtung bereits vorhandenen Mittel zum Kühlen des Geräts, insbesondere seiner elektrischen Verbraucher, genutzt werden, um die einströmende Umgebungsluft abzukühlen und die abgezogene Wärme abzuführen.

Insbesondere kann das Gehäuse selbst Teil der Mittel zum Abführen der von den elektrischen Verbrauchern erzeugten Wärme sein, indem es in direktem thermischen Kontakt mit den Verbrauchern steht und die Wärme beispielsweise an eine Kühlung, insbesondere an einen Economiser abgibt, die wiederum dazu ausgebildet und bestimmt sein kann, die abgezogene Wärme an den Kältekreislauf der Klimatisierungsanlage weiterzuleiten.

Durch den bestehenden thermischen Kontakt zum Gehäuse haben die Kühleinrichtung und somit auch die abgekühlte einströmende Umgebungsluft im Wesentlichen die gleiche Temperatur wie das Gehäuse und der Großteil der Gerätekontaktfläcften im Gehäuseinneren, so dass zum einen gewährleistet ist, dass der Großteil der Luftfeuchtigkeit bereits außerhalb des Gehäuseinneren auskondensiert und zum anderen, dass eine Kondensation der gegebenenfalls in der einströmenden Luft noch enthaltenen Restfeuchte im Gehäuseinneren wegen der Temperaturangleichung zwischen der einströmenden Luft und den Kontaktflächen im Gehäuseinneren unterdrückt wird.

Nach einer technisch besonders einfach zu realisierenden Ausführungsform einer passiven Kühleinrichtung weist diese im Wesentlichen lediglich eine möglichst große Kühloberfläche auf, mit der die einströmende bzw. daran vorbeiströmende Umgebungsluft ausreichend thermalisieren kann, so dass die enthaltene Feuchte an der Kühloberfläche kondensiert.

Um eine Zwangsströmungsverbindung zwischen dem Gehäuseinneren und der Gehäuseumgebung zu bilden, weist die insbesondere als passives Bauteil ausgebildete Kühlvorrichtung wenigstens einen Kühlkanal und/oder Kühlrippen auf. In besonders vorteilhafter Weise ist der Kanal bzw. sind die Kanäle derart ausgebildet, dass die einströmende Luft über einen möglichst langen Weg bis zur Gehäuseöffnung in das Gehäuseinnere geführt wird, also über einen ausreichend langen Weg mit der Kanalwandung thermalisieren kann und sich dabei Luftfeuchte abscheidet. Für eine maximale Thermalisierung ist es außerdem von Vorteil, wenn die Kontaktfläche zwischen einströmender Luft und Kühlkanal, also die Oberfläche der Kanalinnenwand, möglichst großflächig ausgebildet ist. Dies kann beispielsweise durch das Vorsehen mehrere Kühlkanäle erreicht werden, die vorzugsweise alle in einer einzigen Öffnung in das Gehäuseinnere münden. Denkbar ist aber auch, dass jeder Kanal durch eine separate Einlassöffnung mit dem Gehäuseinneren verbunden ist. Denkbar ist auch, dass die Kühlkanäle zumindest bereichsweise als Kühlrippen ausgebildet sind.

Gemäß der Erfindung soll die einströmende Luft durch die Abkühlung in der Kühleinrichtung Feuchtigkeit abscheiden, wobei die in der Luft enthaltene Feuchtigkeit an den Kanalwänden der Kühleinrichtung kondensiert. Damit beispielsweise im Gehäuseinneren angeordneten Elektronikbauteile durch das in der Kühleinrichtung abgeschiedene Kondensat keinen Schaden nehmen, weist die Kühleinrichtung Mittel zum Abführen des Kondensats auf, insbesondere um das Kondensat aus dem Gehäuseinneren zurückzuhalten. Dazu können die Mittel beispielsweise als ein spezielles Abflusssystem in der Kühleinrichtung ausgebildet sein.

Nach einer besonders vorteilhaften Ausführung der Erfindung sind hierzu in der Montagestellung des Gehäuses die Gehäuseöffnung bzw. -öffnungen niveaumäßig höher als der wenigstens eine Kühlkanal angeordnet, so dass kein Kondensat in das Gehäuseinnere gelangen kann. Weiterhin ist es von Vorteil, wenn der wenigstens eine Kühlkanal in Montagestellung des Gehäuses zumindest bereichsweise von der Gehäuseöffnung nach außen in vertikaler Richtung abfällt, so dass vorzugsweise der tiefste Punkt des Kanalverlaufs am Übergang zur Gehäuseumgebung liegt und somit das Kondensat automatisch in die Gehäuseumgebung abfließt.

Um trotz Kondensationskühlung eventuell noch in der einströmenden Luft enthaltene Restfeuchte zu absorbieren, kann nach einer Weiterbildung der Erfindung entlang der Zwangsströmungsverbindung, vorzugsweise zwischen dem Kühlkanal und der Gehäuseöffnung eine mit Trocknungsmittel, beispielsweise Silica-Gel, befüllbarer Durchströmkammer vorgesehen sein. Diese kann beispielsweise als eine Mulde oder Schale ausgebildet sein, in die sämtliche Kühlkanäle vor der Gehäuseöffnung münden.

Sollte sich bei besonders ungünstigen Einsatzbedingungen Kondensat in der Durchströmkammer bilden, so ist es weiterhin von Vorteil, wenn die Durchströmkammer derart ausgebildet ist, dass daran abgeschiedenes Kondenswasser über den wenigstens einen Kühlkanal nach außen abführbar ist und nicht in das Innere des Gehäuses fließt. Dazu können beispielsweise die Kanäle auf einem niedrigeren Höhenniveau in die Durchströmkammer münden als die Gehäuseöffnung.

Nach einer besonders vorteilhaften Ausführungsform der Erfindung sind der wenigstens eine Kühlkanal und/oder die Durchströmkammer und/oder die Kühleinrichtung und/oder das Gehäuse einstückig ausgebildet. Dadurch lassen sich unter anderem Herstellungskosten und Gewicht sparen. Außerdem ist auf diese Weise automatisch erreicht, dass die Kühleinrichtung im thermischen Kontakt mit dem Gehäuse steht. Zum Beispiel können dazu die Kühlkanäle als Kühlrippen und die Durchströmkammer als eine Mulde aus einen beispielsweise metallenem Gehäuseteil ausgefräst bzw. gegossen sein. Metall eignet sich hierbei in besonderer Weise als guter Wärmeleiter.

Bei einer weiteren, besonders bevorzugten Ausgestaltung der Erfindung stehen die einströmende Luft und/oder die Kühleinrichtung und/oder das Gehäuse und/oder die Mittel zum Abführen der von den elektrischen Verbrauchern erzeugten Abwärme mit dem Kältekreislauf der Klimatisierungsanlage und/oder einem Economiser in, insbesondere auch direktem, thermischem Kontakt. Ein Economiser ist ein Wärmeüberträger, insbesondere ein Kühler, zur vorteilhaften Verwertung von Abwärme aus technischen Prozessen und Anlagen, hier also zur Verwertung der von den elektrischen Verbrauchern erzeugten Abwärme und der aus der einströmenden Luft entzogenen Wärme. Insbesondere bei Klimatisierungsanlagen, wie beispielsweise Wärmepumpen, werden Economiser vorteilhaft zur Erhöhung der Leistungszahl der Anlage eingesetzt.

In vorteilhafter Weise kann die einströmende Luft auch zumindest bereichsweise in direktem thermischen Kontakt mit dem Economiser stehen, dessen Kühlflächen bzw. Thermalisierungsflächen typischerweise kälter sind als das damit in thermischen Kontakt stehende Gehäuse oder die Mittel zum Abführen der von den elektrischen Verbrauchern erzeugten Abwärme. Dazu kann der Economiser beispielsweise einen Teil der Kühlkanalwandung der Kühlvorrichtung bilden. Weiterhin können die Kühlkanäle der Kühlvorrichtung derart ausgebildet sein, dass die einströmende Luft entlang der Zwangsströmungsverbindung, vorzugsweise nachdem bereits ein Großteil der Feuchte auskondensiert ist, an den Kühlflächen des Economisers vorbeigeführt bzw. geleitet wird. Dadurch wird in vorteilhafter Weise erreicht, dass die einströmende Luft sogar noch unter die Temperatur der Gehäusewandung und/oder der Luft bzw. der Kontaktflächen im Gehäuseinneren abgekühlt und damit das Risiko einer Betauung im Gehäuseinneren noch weiter minimiert werden kann.

Weitere Ziele, Vorteile, Merkmale und Anwendungsmöglichkeiten der vorliegenden Erfindung ergeben sich aus der nachfolgenden Beschreibung eines Ausführungsbeispieles anhand der Zeichnung. Dabei bilden alle beschriebenen und/oder bildlich dargestellten Merkmale für sich oder in beliebiger sinnvoller Kombination den Gegenstand der vorliegenden Erfindung, auch unabhängig von ihrer Zusammenfassung in den Ansprüchen oder deren Rückbeziehung.

Es zeigen:
- Fig. 1:: eine perspektivische Ansicht von oben auf ein mögliches Ausführungsbeispiel des erfindungsgemäßen Gehäuses,
- Fig. 2:: eine perspektivische Ansicht von unten auf das Gehäuse gemäß Fig. 1,
- Fig. 3:: eine Draufsicht auf die Oberseite des Gehäuses gemäß Fig. 1 und
- Fig. 4:: einen Schnitt A-A durch das Gehäuse gemäß Fig. 3 mit Economiser.

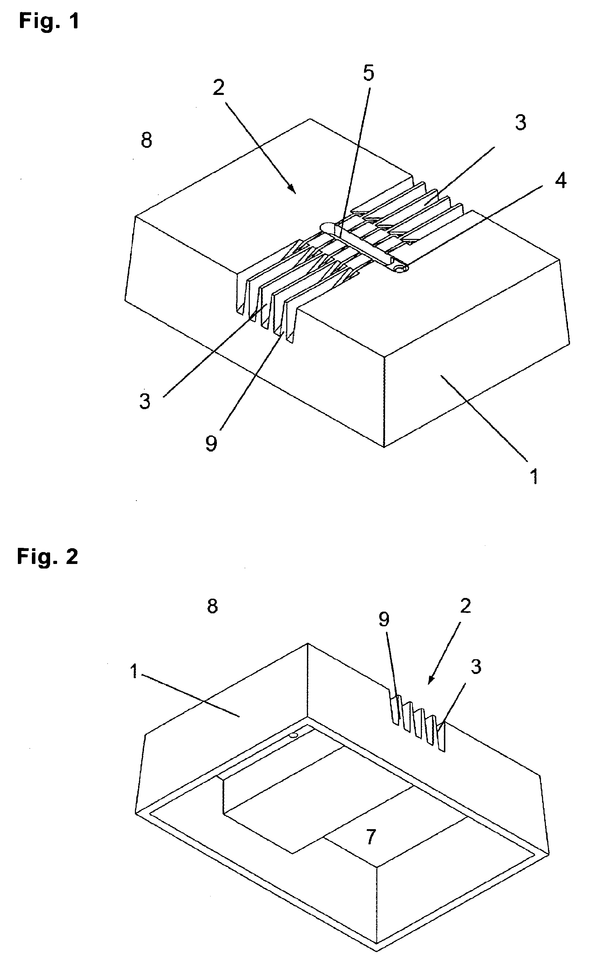

Fig. 1 bis Fig. 4 zeigen ein mögliches Ausführungsbeispiel eines erfindungsgemäßen Gehäuses 1, an dessen Außenseite eine Kühleinrichtung 2 vorgesehen ist, die dazu dient, die über die Gehäuseöffnung 4 in das Gehäuseinnere 7 einströmende Luft aus der Gehäuseumgebung 8 derart abzukühlen, dass die in der einströmenden Umgebungsluft enthaltene Feuchtigkeit in der Kühleinrichtung 2 im Wesentlichen auskondensiert, und es im Gehäuseinneren 7 zu keiner Betauung der dort angeordneten, hier nicht gezeigten elektrischen Verbraucher, insbesondere Elektronikbauteilen, kommt.

Im vorliegenden Ausführungsbeispiel sind die Kühleinrichtung 2 und das Gehäuse 1 einstückig ausgebildet und aus Metall hergestellt, so dass automatisch eine thermische Kopplung zwischen Kühleinrichtung und Gehäuse gegeben ist. Das Gehäuse 1 mit Kühleinrichtung 2 ist hier nur als Halbschale ausgebildet. Eine hier nicht gezeigte Gerätebodenplatte, auf der unter anderem die elektrischen Verbraucher angeordnet sein können, kann beispielsweise den Abschluss der gezeigten Gehäusehalbschale zu einem vollständig geschlossenen Gehäuse bilden. Insbesondere kann auch die von den elektrischen Verbrauchern erzeugte Abwärme über das vorzugsweise aktiv gekühlte Gehäuse 1 übergeführt werden.

Zum Abkühlen der einströmenden Umgebungsluft weist die Kühleinrichtung 2 insgesamt zehn, zumindest bereichsweise als Kühlrippen 9 ausgebildete Kühlkanäle 3 auf, von denen je fünf auf zwei gegenüberliegenden Seiten des Gehäuses 1 angeordnet sind. Alle Kühlkanäle 3 münden in eine als Mulde bzw. Schale ausgebildete Durchströmkammer 5, die wiederum über die Gehäuseöffnung 4 in Strömungsverbindung mit dem Gehäuseinneren 7 steht. Die Kühlkanäle 3, die Durchströmkammer 5 und der Lufteinlass 4 bilden somit eine vordefinierte Zwangsströmungsverbindung, in der die einströmende Luft so geführt wird, dass sie möglichst lange mit der Kühleinrichtung 2 in Kontakt steht und dabei die in ihr enthaltene Feuchtigkeit an der Kontaktfläche der Kühlkanäle auskondensieren kann. Hinsichtlich einer maximalen Thermalisierung ist insbesondere die Oberfläche der Kühlkanäle 3 großflächig ausgebildet. An einer bestimmten Position in Richtung Durchströmkammer 5 verengen sich die Kühlkanäle 3.

Zum Abführen des an den Kühlrippen 9 und den Kühlkanälen 3 abgeschiedenen Kondensats steigt der Boden der Kühlkanäle 3 in Richtung der Durchströmkammer 5 an, so dass in den Kühlkanälen abgeschiedenes Kondenswasser in Montagestellung des Gehäuses 1 in keinem Fall in das Gehäuseinnere 7 gelangen kann, sondern vorzugsweise in die Gehäuseumgebung 8 abfließt. Insbesondere ist die Gehäuseöffnung 4 niveaumäßig höher angeordnet als die Kühlkanäle 3.

Die Durchströmkammer 5 ist vornehmlich dazu ausgebildet, um mit einem Trocknungsmittel, beispielsweise Silica-Gel, befüllt zu werden, das die in der einströmenden, vorzugsweise bereits vorgetrockneten Luft enthaltene Restfeuchte auffangen soll.

Damit Kondenswasser, das sich eventuell unter ungünstigen Einsatzbedingungen in der Durchströmkammer 5 abscheidet, nicht ins Gehäuseinnere 7 fließt, münden die Kühlkanäle 3 auf einem niedrigerem Höhenniveau in die Durchströmkammer 5 als der Lufteinlass 4, so dass das Wasser ggf. über die Kühlkanäle 3 in die Gehäuseumgebung 8 abfließen kann.

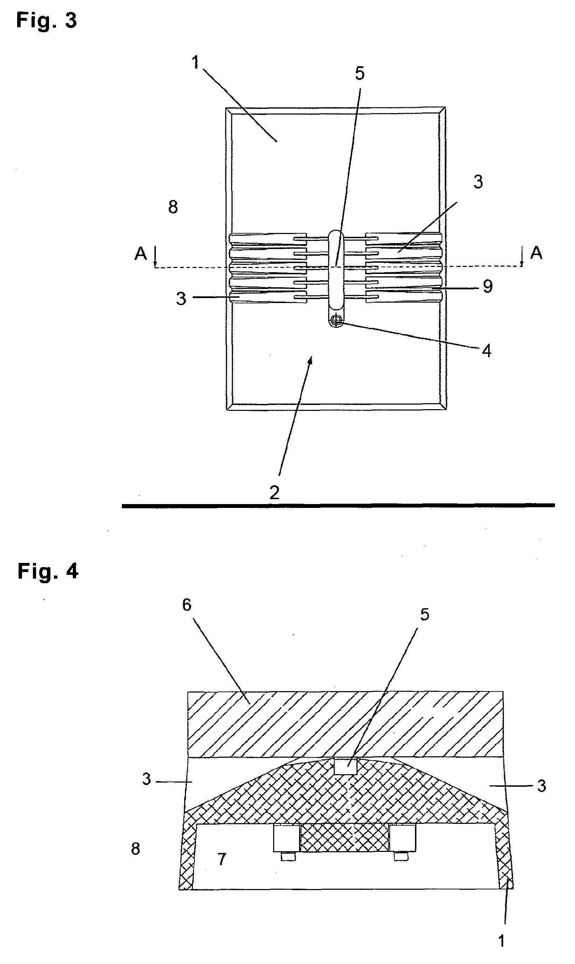

Wie in Fig. 4 gezeigt, ist das Gehäuse 1, und damit das gesamte, hier nicht gezeigte Gerät, von unten an einem Economiser 6 angebracht und steht insbesondere über diesen in thermischem Kontakt mit dem Kältekreislauf der hier ebenso nicht gezeigten Klimatisierungsanlage, so dass das Gerät mit den elektrischen Verbrauchern, das Gehäuse 1 und die Kühlvorrichtung 2 über ein gemeinsam genutztes Mittel bzw. einen gemeinsam genutzten thermischen Kontakt aktiv gekühlt werden und insbesondere im Wesentlichen die gleiche Temperatur aufweisen, wobei der Economiser selbst eine tiefere Temperatur aufweisen kann. Vor allem kann die von den elektrischen Verbrauchern erzeugte Abwärme und die der einströmenden Luft entzogene Wärme durch den Economiser 6 vorteilhaft verwertet werden, um die Leistungszahl der Klimatisierungsanlage zu steigern.

Im vorliegenden Ausführungsbeispiel hat der Economiser 6 die zusätzliche Funktion, mit seiner Unterseite einen Teil der erfindungsgemäßen Kühlvorrichtung 2, d.h. einen Teil der Kühlkanalwandung 3 und Durchströmkammerwandung 5 zu bilden, so dass effektiv eine Zwangsströmungsverbindung zwischen Gehäuseumgebung 8 und Gehäuseinnerem 7 erzeugt wird. D. h. einströmende Luft steht auch in direktem thermischen Kontakt mit den Kühlkontaktflächen des Economisers 6. Vor allem dort, wo sich die Kühlkanäle 3 insbesondere in vertikaler Richtung verengen, wird die einströmende Luft zwangsweise an der Unterseite des Economisers 6 vorbeigeführt und abgekühlt. Vorzugsweise ist bereits der Großteil der Feuchte an den Kühlrippen im Einlassbereich der Kühlvorrichtung auskondensiert, so dass die Gefahr einer übermäßigen Kondensatbildung an der Unterseite des Economisers 6, insbesondere im Bereich der Kühlkanalverengung und der Durchströmkammer 5, vermieden wird. In diesem Bereich erfolgt nur noch eine Endtrocknung der einströmenden Luft. Vor allem aber wird in vorteilhafter Weise erreicht, dass die einströmende Luft durch die im Vergleich zu den Kühlkanal- und Kühlrippenwandungen kältere Economiserunterseite 6 sogar noch unter die Temperatur der Gehäusewandung 1 und/oder der Luft bzw. der Kontaktflächen im Gehäuseinneren 7 abgekühlt wird, so dass das Risiko einer Betauung im Gehäuseinneren 7 noch weiter minimiert werden kann.

### BEZUGSZEICHENLISTE

- 1: Gehäuse
- 2: Kühleinrichtung
- 3: Kühlkanal
- 4: Gehäuseöffnung
- 5: Durchströmkammer
- 6: Economiser
- 7: Gehäuseinnere
- 8: Gehäuseumgebung
- 9: Kühlrippen

## Patentansprüche

1. Gehäuse (1) für ein Gerät zum Betreiben einer Klimatisierungsanlage, insbesondere einer Wärmepumpe, mit im Gehäuseinneren (7) angeordneten elektrischen Verbrauchern und Mitteln zum Abführen der von den elektrischen Verbrauchern erzeugten Abwärme, wobei im Bereich der Gehäusewandung eine Kühleinrichtung (2) zum Kondensieren der Feuchtigkeit vorgesehen ist, die in der in das Gehäuseinnere (7) einströmenden Umgebungsluft enthalten ist, **dadurch gekennzeichnet, dass** die Kühlvorrichtung (2) zusammen mit wenigstens einer Gehäuseöffnung (4) im Gehäuse (1) eine Zwangsströmungsverbindung für die aus der Gehäuseumgebung (8) in das Gehäuseinnere (7) einströmende Umgebungsluft bildet, wobei das Gehäuse (1) bis auf die wenigstens eine Gehäuseöffnung (4) im Wesentlichen luftdicht ausgebildet ist.

2. Gehäuse (1) nach Anspruch 1,
**dadurch gekennzeichnet, dass** die Kühleinrichtung (2) als passives Bauteil ausgebildet ist und mit den Mitteln zum Abführen der von den elektrischen Verbrauchern erzeugten Abwärme, insbesondere Ober das Gehäuse (1), in thermischem Kontakt steht.

3. Gehäuse (1) nach Anspruch 1 oder 2.
**dadurch gekennzeichnet, dass** die Kühleinrichtung (2) wenigstens einen Kühlkanal (3) und/oder Kühlrippen (9) für die Kondensation der in der Umgebungsluft enthaltenen Feuchtigkeit aufweist.

4. Gehäuse (1) nach einem der Ansprüche 1 bis 3,
**dadurch gekennzeichnet, dass** die Kühleinrichtung (2) Mittel zum Abführen des abgeschiedenen Kondensats aufweist, insbesondere zum Rückhalten von Kondensat aus dem Gehäuseinneren (7).

5. Gehäuse (1) nach Anspruch 3 oder 4,
**dadurch gekennzeichnet, dass** in Montagestellung des Gehäuses (1) die Gehäuseöffnung (4) niveaumäßig höher als der wenigstens eine Kühlkanal (3) angeordnet ist.

6. Gehäuse (1) nach einem der Ansprüche 3 bis 5, **dadurch gekennzeichnet, dass** in Montagestellung des Gehäuses (1) der wenigstens eine Kühlkanal (3) zumindest bereichsweise von der Gehäuseöffnung (4) nach außen in vertikaler Richtung abfällt.

7. Gehäuse (1) nach einem der Ansprüche 3 bis 6,
**dadurch gekennzeichnet, dass** die Kühlvorrichtung (2), vorzugsweise zwischen dem wenigstens einen Kühlkanal (3) und der wenigstens einen Gehäuseöffnung (4), eine mit Trocknungsmittel befüllbare Durchströmkammer (5) aufweist.

8. Gehäuse (1) nach einem der Ansprüche 1 bis 7,
**dadurch gekennzeichnet, dass** die einströmende Luft und/oder die Kühleinrichtung (2) und/oder das Gehäuse (1) und/oder die Mittel zum Abführen der von den elektrischen Verbrauchern erzeugten Abwärme zum Verwerten der abgeführten Wärme mit dem Kältekreislauf der Klimatisierungsanlage und/oder mit einem Economiser (6) in, insbesondere direktem, thermischem Kontakt stehen.

9. Gerät zum Betreiben einer Klimatisierungsanlage und/oder eine Klimatisierungsanlage mit einem Gehäuse (1) nach einem der vorherigen Ansprüche.

## Claims

1. Housing (1) for a device for operating an air-conditioning system, in particular a heat pump, having electrical loads arranged in the interior (7) of the housing and means for conducting away the waste heat generated by the electrical loads, wherein a cooling apparatus (2) for condensing the moisture is provided in the region of the housing wall, which moisture is contained in the ambient air flowing into the interior (7) of the housing, **characterized in that** the cooling apparatus (2) forms, together with at least one housing opening (4) in the housing (1), a forced flow connection for the ambient air flowing into the interior (7) of the housing from the surroundings (8) of the housing, wherein the housing (1) is embodied in a substantially air-tight fashion with the exception of the at least one housing opening (4).

2. Housing (1) according to Claim 1,
**characterized in that** the cooling apparatus (2) is embodied as a passive component and is in thermal contact with the means for conducting away, in particular via the housing (1), the waste heat generated by the electrical loads.

3. Housing (1) according to Claim 1 or 2,
**characterized in that** the cooling apparatus (2) has at least one cooling duct (3) and/or cooling fins (9) for the condensation of the moisture contained in the ambient air.

4. Housing (1) according to one of Claims 1 to 3,
**characterized in that** the cooling apparatus (2) has means for conducting away the precipitated condensate, in particular for holding back condensate from the interior (7) of the housing.

5. Housing (1) according to Claim 3 or 4,
**characterized in that** in the mounted position of the housing (1) the housing opening (4) is arranged at a higher level than the at least one cooling duct (3).

6. Housing (1) according to one of Claims 3 to 5,
**characterized in that** in the mounted position of the housing (1) the at least one cooling duct (3) drops away, at least in certain areas, outwards from the housing opening (4) in the vertical direction.

7. Housing (1) according to one of Claims 3 to 6,
**characterized in that** the cooling apparatus (2) has, preferably between the at least one cooling duct (3) and the at least one housing opening (4), a through-flow chamber (5) which can be filled with desiccant.

8. Housing (1) according to one of Claims 1 to 7,
**characterized in that** the inflowing air and/or the cooling apparatus (2) and/or the housing (1) and/or the means for conducting away the waste heat generated by the electrical loads is in, in particular direct, thermal contact with the refrigerant circuit of the air-conditioning system and/or with an economizer (6), in order to utilize the discharged heat.

9. Device for operating an air-conditioning system and/or an air-conditioning system having a housing (1) according to one of the preceding claims.

## Revendications

1. Boîtier (1) pour un appareil pour faire fonctionner une installation de climatisation, en particulier une pompe à chaleur, comprenant des consommateurs électriques disposés à l'intérieur du boîtier (7) et des moyens pour évacuer la chaleur perdue générée par les consommateurs électriques, un dispositif de refroidissement (2) pour condenser l'humidité contenue dans l'air ambiant entrant à l'intérieur du boîtier (7) étant prévu dans la région de la paroi du boîtier, **caractérisé en ce que** le dispositif de refroidissement (2) forme, conjointement avec au moins une ouverture de boîtier (4) dans le boîtier (1), une liaison fluidique forcée pour l'air ambiant entrant à l'intérieur du boîtier (7) depuis l'environnement du boîtier (8), le boîtier (1) étant réalisé essentiellement de manière étanche à l'air à l'exception de l'au moins une ouverture de boîtier (4).

2. Boîtier (1) selon la revendication 1,
**caractérisé en ce que** le dispositif de refroidissement (2) est réalisé sous forme de composant passif et est en contact thermique avec les moyens d'évacuation de la chaleur perdue générée par les consommateurs électriques, en particulier par le biais du boîtier (1).

3. Boîtier (1) selon la revendication 1 ou 2,
**caractérisé en ce que** le dispositif de refroidissement (2) présente au moins un canal de refroidissement (3) et/ou des ailettes de refroidissement (9) pour la condensation de l'humidité contenue dans l'air ambiant.

4. Boîtier (1) selon l'une quelconque des revendications 1 à 3,
**caractérisé en ce que** le dispositif de refroidissement (2) présente des moyens pour évacuer le condensat séparé, en particulier pour retenir le condensat provenant de l'intérieur du boîtier (7).

5. Boîtier (1) selon la revendication 3 ou 4,
**caractérisé en ce que** dans la position de montage du boîtier (1), l'ouverture de boîtier (4) est disposée à un niveau plus élevé que l'au moins un canal de refroidissement (3).

6. Boîtier (1) selon l'une quelconque des revendications 3 à 5,
**caractérisé en ce que**, dans la position de montage du boîtier (1), l'au moins un canal de refroidissement (3) descend dans la direction verticale vers l'extérieur au moins en partie depuis l'ouverture de boîtier (4).

7. Boîtier (1) selon l'une quelconque des revendications 3 à 6,
**caractérisé en ce que** le dispositif de refroidissement (2), de préférence entre l'au moins un canal de refroidissement (3) et l'au moins une ouverture de boîtier (4), présente une chambre de passage de l'écoulement (5) pouvant être remplie d'un agent de séchage.

8. Boîtier (1) selon l'une quelconque des revendications 1 à 7,
**caractérisé en ce que** l'air entrant et/ou le dispositif de refroidissement (2) et/ou le boîtier (1) et/ou les moyens pour évacuer la chaleur perdue générée par les consommateurs électriques sont en contact thermique, notamment direct, pour exploiter la chaleur évacuée, avec le circuit frigorigène de l'installation de climatisation et/ou avec un économiseur (6).

9. Appareil pour faire fonctionner une installation de climatisation et/ou installation de climatisation comprenant un boîtier (1) selon l'une quelconque des revendications précédentes.
